# EUROPEAN PATENT APPLICATION

(11) **EP 3 827 987 A1**
(43) Date of publication of application: **02.06.2021**
(21) Application number: 19841550.7
(22) Date of filing: 23.07.2019
(51) Int. Cl.: B41F 15/36, H01L 31/18, H01L 31/0224, H01L 31/028, H01L 31/04

(54) **CRYSTALLINE SILICON SOLAR CELL SCREEN FOR POSITIVE ELECTRODE HOLLOW MOLDING**

(30) Priority: 24.07.2018 CN 201810816108
(71) Applicant: Zhejiang Aiko Solar Energy Technology Co., Ltd., Yiwu, Zhejiang 322009 (CN); Guangdong Aiko Solar Energy Technology Co., Ltd., Foshan, Guangdong 528000 (CN)
(72) Inventor: LIN, Kang-Cheng, Yiwu, Zhejiang 322009 (CN); FENG, Mingzhang, Yiwu, Zhejiang 322009 (CN); FANG, Jiebin, Yiwu, Zhejiang 322009 (CN); CHEN, Gang, Yiwu, Zhejiang 322009 (CN)
(74) Representative: Murgitroyd & Company
(86) International application number: PCT/CN2019/097299
(87) International publication number: WO 2020/020159

(57) **Abstract**

Disclosed is a screen printing plate (5) for manufacturing a crystalline silicon solar cell, a positive electrode of the crystalline silicon solar cell comprising a positive electrode busbar (1), a positive electrode grid (2) and a break-proof grid structure (3), wherein the screen printing plate (5) is used at least for integrally printing and forming the positive electrode grid (2) and the break-proof grid structure (3). The screen printing plate (5) is provided with a blocking portion for blocking the passage of a paste, the blocking portion is a photosensitive emulsion (6) or a non-photosensitive emulsion, and the blocking portion corresponds to the break-proof grid structure (3) of the positive electrode and is used for forming a hollow-out groove (4) in the break-proof grid structure (3) when the positive electrode is printed. The blocking portion is positioned such that the hollow-out groove (4) is formed in a portion of the break-proof grid structure (3) between the positive electrode busbar (1) and the positive electrode grid (2).

## Description

### FIELD

The present disclosure relates to a structure of a solar cell, and specifically to a screen printing plate of a crystalline silicon solar cell for positive electrode hollow-out forming.

### BACKGROUND

The positive electrode of the crystalline silicon solar cell is designed to include a busbar and a grid perpendicular to the busbar. The function of a grid line is to collect a photo-generated current to a busbar line. If a breakage and a false printing of the grid line occurs upon printing, the collection of the photo-generated current will be affected and the cell efficiency will be affected. If a cell piece with a grid broken is used to make a module, a hot spot of local heating will appear at the broken grid, which will affect the service life of the module.

There are many reasons for grid breakage upon solar cell printing. The following reasons will all cause grid breakage to different degrees: screen parameters are not set correctly, a line width of the screen printing plate does not match the paste, the screen printing plate is blocked, the scraper is worn, the viscosity of the paste is excessively high or the paste becomes dry, score lines on silicon wafer, and so on. When the scraper passes by the busbar to a juncture of the busbar and the grid upon screen printing, since ink penetration amount drops rapidly, the printing height of the grid line falls accordingly, which also causes a certain proportion of grid breakage. In view of this case, such a problem of grid breakage is typically addressed by adding a trapezoidal break-proof grid of a certain width at the connection of the busbar and the grid.

A conventional break-proof grid design may be used to reduce the probability of grid breakage when the printing is performed on the front side of the cell, but a proportion of the grid breakage caused by the conventional design has already failed to satisfy the demands in the market as the modules have increasingly high requirements for the cell quality. Hence, a more reasonable and practical design is needed to reduce the proportion of the grid breakage.

### SUMMARY

An object of the present disclosure provides a screen printing plate of a crystalline silicon solar cell for positive electrode hollow-out forming. When the screen printing plate is used to print the positive electrode, a hollow-out groove can be formed in a break-proof grid structure, the probability of grid breakage when the front-side electrode is printed can be reduced effectively. The function of reducing a hot spot effect of local heating of the component can be achieved by preventing the grid breakage.

According to the present disclosure, there is provided a screen printing plate for manufacturing a crystalline silicon solar cell. The positive electrode of the crystalline silicon solar cell comprises a positive electrode busbar, a positive electrode grid, and a break-proof grid structure. The screen printing plate is at least used for integral printing forming of the positive electrode grid and the break-proof grid structure. The screen printing plate is provided with a blocking portion for blocking the passage of a paste. The blocking portion corresponds to the break-proof grid structure of the positive electrode and is used for forming a hollow-out groove at a position in the break-proof grid structure corresponding to the blocking portion when the positive electrode is printed. The blocking portion is positioned such that the hollow-out groove is formed in a portion of the break-proof grid structure between the positive electrode busbar and the positive electrode grid. The existence of the hollow-out groove may reduce the probability of grid breakage when the positive electrode is printed.

The screen printing plate of the present disclosure is provided with the blocking portion. When the positive electrode is printed, the hollow-out groove is formed at a position where the break-proof grid structure corresponds to the blocking portion, so as to reduce the probability of grid breakage when the positive electrode is printed, to ensure that the grid line collects photo-generated carriers to a maximum extent, and to improve the efficiency of the cell. At the same time, since the cell with the broken grid is used to make a component, a hot spot effect of the component will be increased. The positive electrode prevents grid breakage through the hollow-out groove to achieve a function of reducing the hot spot effect of local heating of the component.

The hollow-out design of the positive electrode may further improve the break-proof grid effect at the connection of the busbar and the grid. The hollow-out design functions in a way that when the scraper passes by the square hollow-out region upon printing, the height of the break-proof grid region slowly rises along the printing direction, thereby further enhancing the break-proof grid effect.

In some embodiments, the blocking portion is a photosensitive emulsion or non-photosensitive emulsion.

In some embodiments, the screen printing plate comprises a break-proof grid forming region which allows a paste to pass therethrough to form the break-proof grid structure. The break-proof grid forming region is an octagon comprising a rectangle located in the middle and two isosceles trapezoids that are located at both sides of the rectangle and are provided symmetrically with the rectangle as a center. The rectangle spans the positive electrode busbar and the left and right ends of the rectangle extend out of the positive electrode busbar. The extended region is an extensional break-proof region of a rectangle shape. Both ends of the isosceles trapezoid are respectively in contact with the extensional break-proof region and the positive electrode grid. The isosceles trapezoid is a tapered region with a cross section gradually reducing in a direction from the positive electrode busbar to the positive electrode grid. The blocking portion is located within the isosceles trapezoid or spans the extensional break-proof region and the isosceles trapezoid.

In some embodiments, the blocking portion is arranged in a lengthwise direction of the positive electrode grid. Alternatively, the blocking portion is arranged in a direction perpendicular to the lengthwise direction of the positive electrode grid.

In some embodiments, the number of the blocking portions is one or more, so that one or more hollow-out grooves are formed in each break-proof grid structure.

In some embodiments, the blocking portion is in a shape of a rectangle or circle. In some examples, the length and width of the rectangle is selected from a range of 0.034-0.084 mm, a diameter of the circle is in a range of 0.034-0.084 mm. The distance between a center of the blocking portion and an edge of the positive electrode busbar is in a range of 0.033-0.068mm.

In some embodiments, a width of a lower base of the isosceles trapezoid of the break-proof grid forming region is in a range of 0.050-0.500mm, a width of an upper base of the isosceles trapezoid is the same as the width of the positive electrode grid, and a height of the isosceles trapezoid is in a range of 0.400-1.600mm.

As compared with the prior art, the screen printing plate of the present disclosure is provided with the blocking portion. When the positive electrode is printed, the hollow-out groove is formed at a position where the break-proof grid structure corresponds to the blocking portion, as so to effectively reduce the probability of grid breakage when the front-side electrode is printed, to ensure that the grid line collects photo-generated carriers to a maximum extent, and to improve the efficiency of the cell. At the same time, since the cell with the broken grid is used to make a component, a hot spot effect of the component will be increased. By preventing the grid breakage, the present disclosure achieves a function of reducing the hot spot effect of local heating of the component and improves the service life of the component. The screen printing plate structure according to the present disclosure is simple in structural design, has an excellent technical effect, and has a wide scope of application.

### BRIEF DESCRIPTION OF THE DRAWINGS

The present disclosure will be described in more detail hereinafter with reference to figures and specific embodiments.
FIG. 1 is a front view of a crystalline silicon solar cell manufactured with a screen printing plate according to the present disclosure;
FIG. 2 is a structural schematic view of a front side of the positive electrode of the crystalline silicon solar cell manufactured with the screen printing plate according to the present disclosure;
FIG. 3 is a structural schematic view of a rear side of the positive electrode of the crystalline silicon solar cell manufactured with the screen printing plate according to the present disclosure;
FIG. 4 is a structural schematic view of a rear side of a break-proof grid structure in the positive electrode of the crystalline silicon solar cell manufactured with the screen printing plate according to the present disclosure;
FIG. 5 is a structural schematic view of a front side of the screen printing plate according to the present disclosure;
FIG. 6 is a structural schematic view showing a change of height of a square hollow-out region in the positive electrode of the crystalline silicon solar cell manufactured with the screen printing plate according to the present disclosure before and after printing.

### Parts denoted by reference numbers

1 positive electrode busbar, 2 positive electrode grid, 3 break-proof grid structure, 4 hollow-out groove, 5 screen printing plate, 6 photosensitive emulsion, 7 busbar region, 8 break-proof grid region without hollow-out groove superimposed, 9 break-proof grid region with hollow-out groove superimposed.

### DETAILED DESCRIPTION

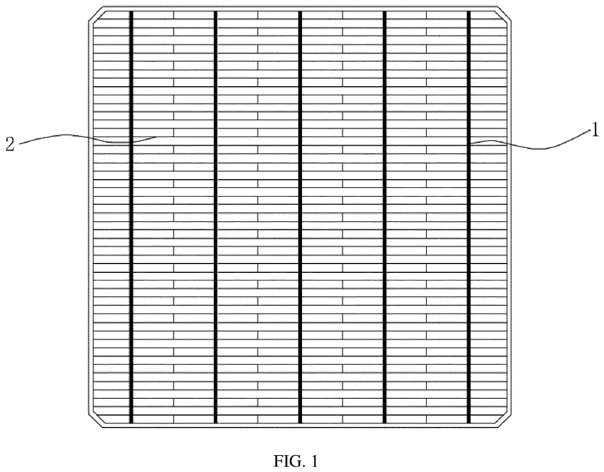

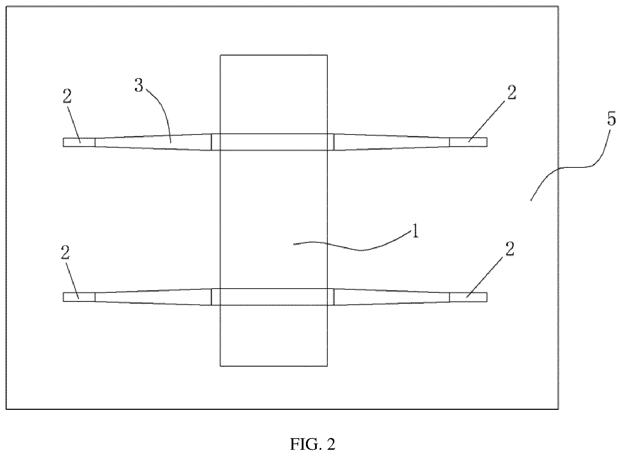

FIGS. 1-6A show a screen printing plate of a crystalline silicon solar cell for positive electrode hollow-out forming. The positive electrode of the crystalline silicon solar cell comprises a positive electrode busbar 1, a positive electrode grid 2, and a break-proof grid structure 3, wherein the break-proof grid structure 3 and the positive electrode grid 2 are integrally printed and formed; the printed break-proof grid structure 3 and the positive electrode grid 2 form a line, and are both perpendicular to the positive electrode busbar 1. The break-proof grid structure 3 is an octagon; the break-proof grid structure 3 comprises a rectangular grid segment located in the middle and two isosceles trapezoidal grid segments that are located at both sides of the rectangular grid segment and are provided symmetrically with the rectangular grid segment as a center. The isosceles trapezoidal grid segment is a tapered grid segment with a cross section gradually reducing in a direction from the positive electrode busbar 1 to the positive electrode grid 2.

To obtain the above positive electrode, the screen printing plate 5 comprises a break-proof grid forming region which allows a paste to pass therethrough to form the break-proof grid structure 3. To obtain the above break-proof grid structure 3, the break-proof grid forming region of the screen printing plate 5 is an octagon comprising a rectangle located in the middle and two isosceles trapezoids that are located at both sides of the rectangle and are provided symmetrically with the rectangle as a center. The rectangle spans the positive electrode busbar 1 and left and right ends of the rectangle extend out of the positive electrode busbar 1. The extended region is an extensional break-proof region of a rectangle shape. Both ends of the isosceles trapezoid are respectively in contact with the extensional break-proof region and the positive electrode grid 2. The isosceles trapezoid is a tapered region with a cross section gradually reducing in a direction from the positive electrode busbar 1 to the positive electrode grid 2.

In the present embodiment, in a non-limiting manner, a photosensitive emulsion 6 is disposed to protrude from a front side of the screen printing plate 5. The photosensitive emulsion 6 corresponds to the break-proof grid structure 3 of the positive electrode. When the positive electrode is printed, a hollow-out groove 4 is formed at a position of the back side of the break-proof grid structure 3 corresponding to the photosensitive emulsion 6, so as to reduce the probability of grid breakage when the positive electrode is printed. It is to be understood that the photosensitive emulsion 6 may also be disposed on the back side of the screen printing plate 5. Alternatively, a non-photosensitive emulsion or other blocking portions blocking the passage of the paste may be used to replace the photosensitive emulsion 6. In some embodiments, the blocking portion is located in the isosceles trapezoid or spans the extensional break-proof region and the isosceles trapezoid.

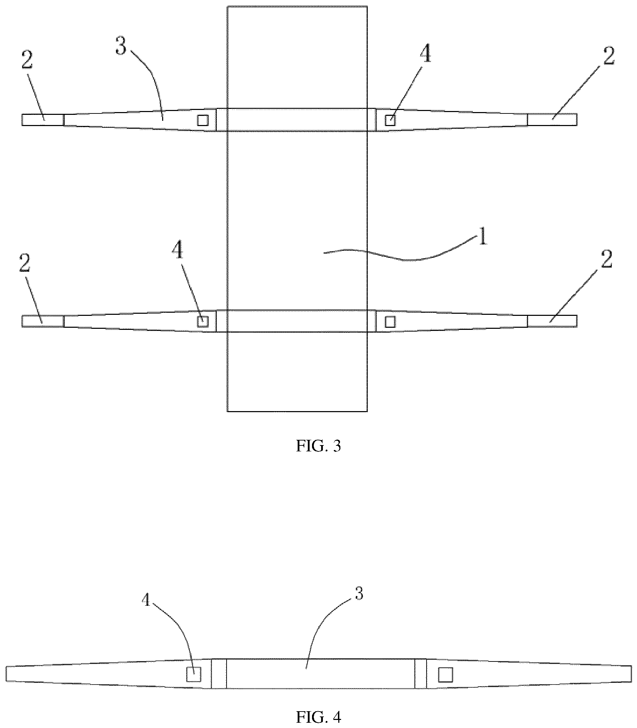

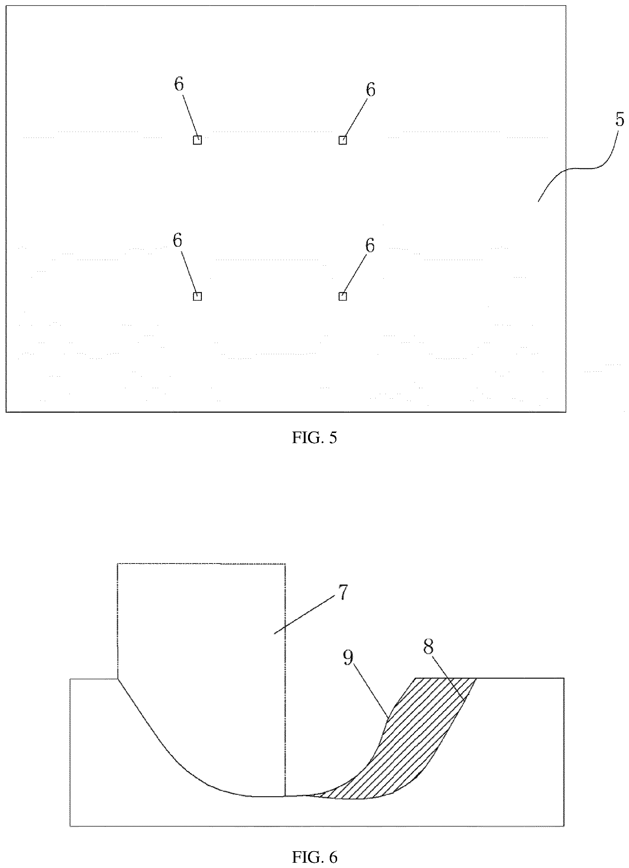

In some embodiments, the blocking portion includes one or more blocking portions, so that one or more hollow-out grooves 4 are formed on the back side of each break-proof grid structure 3. In some embodiments, there are a plurality of photosensitive emulsions 6 with the same structure. The plurality of photosensitive emulsions 6 may be arranged in a lengthwise direction of the positive electrode grid 2 or arranged in a direction perpendicular to the lengthwise direction of the positive electrode grid 2. By way of example and as shown in FIGS. 4 and 5, the number of photosensitive emulsions 6 is twice that of the break-proof grid structures 3, so that two hollow-out grooves 4 are formed on the back side of each break-proof grid structure 3, and are located on both sides of the positive electrode busbar 1. It is to be appreciated that each break-proof grid structure 3 may also include other numbers of hollow-out grooves 4.

As an example, the photosensitive emulsion 6 may be square with a length of the photosensitive emulsion 6 being 0.050 mm. The distance between the center of the photosensitive emulsion 6 and an edge of the positive electrode busbar 1 is 0.038 mm. Alternatively, the photosensitive emulsion 6 may have other shapes such as rectangle, a circle, an ellipse, and the like.

As a variation of the present embodiment, the length of the photosensitive emulsion 6 may also in a range of 0.034-0.084mm, and the distance between the center of the photosensitive emulsion 6 and the edge of the positive electrode busbar 1 may be in a range of 0.033-0.068mm. By way of example, when the photosensitive emulsion 6 is rectangular, the values of its length and width are selected from a range of 0.034-0.084mm. In case that the photosensitive emulsion 6 is circular, its diameter is in a range of 0.034-0.084mm.

In some embodiments, a width of a lower base of the isosceles trapezoid of the break-proof grid forming region is in a range of 0.050-0.500mm, a width of an upper base of the isosceles trapezoid is the same as the width of the positive electrode grid 2, and a height of the isosceles trapezoid is in a range of 0.400-1.600mm.

A principle of forming the hollow-out groove of the positive electrode manufactured with the screen printing plate of the present disclosure is as follows: when a screen printing plate is designed for the solar cell, a protruding square photosensitive emulsion is added at a position of the screen printing plate corresponding to the hollow-out groove of the break-proof grid structure, to make the break-proof grid structure hollow. When the positive electrode is printed in reality, the hollow-out groove 4 is formed on the back side of the break-proof grid structure 3.

When the screen printing plate of the present disclosure is used in the positive electrode hollow-out forming, the length of the hollow-out groove 4 formed on the back side of the break-proof grid structure 3 is in a range of 0.034-0.084 mm. The functional principle of the hollow-out groove 4 is shown in Fig. 6. When the scraper passes by the busbar region 7 upon printing, the printing height of the corresponding paste gradually reduces until the printing enters the break-proof grid region 8 of the non-superimposed hollow-out groove, and the printing height gradually increases; when the printing enters the break-proof grid region 9 of the superimposed hollow-out groove, the printing height rises rapidly, thereby further enhancing the break-proof grid effect.

Therefore, the screen printing plate of the present disclosure is provided with the photosensitive emulsion protruding from the front side. When the positive electrode is printed, the hollow-out groove is formed at a position where the back side of the break-proof grid structure corresponds to the photosensitive emulsion, so as to effectively reduce the probability of grid breakage when the front-side electrode is printed, to ensure that the grid line collects photo-generated carriers to a maximum extent, and to improve the efficiency of the cell. At the same time, since the cell with the broken grid is used to make a component, a hot spot effect of the component will be increased. By preventing the grid breakage, the present disclosure achieves a function of reducing the hot spot effect of local heating of the component and improves the service life of the component. The present disclosure is simple in structural design and has a wide scope of application.

The above-mentioned embodiments of the present disclosure are not intended to limit the scope of protection of the present disclosure, and the embodiments of the present disclosure are not limited thereto. Other various modifications, substitutes or variations to the above structures of the present disclosure according to the above content of the present disclosure as well as ordinary technical knowledge and customary means in the art without departing from the above basic technical ideas of the present disclosure should all fall within the protection scope of the present disclosure.

## Claims

1. A screen printing plate for manufacturing a crystalline silicon solar cell, a positive electrode of the crystalline silicon solar cell comprising a positive electrode busbar (1), a positive electrode grid (2) and a break-proof grid structure (3), wherein the screen printing plate is at least used for integral printing forming of the positive electrode grid (2) and the break-proof grid structure (3), wherein the screen printing plate (5) is provided with a blocking portion for blocking the passage of a paste, the blocking portion corresponding to the break-proof grid structure (3) of the positive electrode and being used for forming a hollow-out groove (4) at a position in the break-proof grid structure (3) corresponding to the blocking portion when the positive electrode is printed, and wherein the blocking portion is positioned such that the hollow-out groove (4) is formed in a portion of the break-proof grid structure (3) between the positive electrode busbar (1) and the positive electrode grid (2).

2. The screen printing plate for manufacturing a crystalline silicon solar cell of claim 1, wherein the blocking portion is a photosensitive emulsion (6) or non-photosensitive emulsion.

3. The screen printing plate for manufacturing a crystalline silicon solar cell of claim 1, wherein the screen printing plate (5) comprises a break-proof grid forming region which allows a paste to pass therethrough to form the break-proof grid structure (3), wherein the break-proof grid forming region is an octagon comprising a rectangle located in the middle and two isosceles trapezoids that are located at both sides of the rectangle and are provided symmetrically with the rectangle as a center, the rectangle spans the positive electrode busbar (1) and left and right ends of the rectangle extend out of the positive electrode busbar (1), the extended region is an extensional break-proof region of a rectangle shape, both ends of the isosceles trapezoid are respectively in contact with the extensional break-proof region and the positive electrode grid (2), the isosceles trapezoid is a tapered region with a cross section gradually reducing in a direction from the positive electrode busbar (1) to the positive electrode grid (2), and the blocking portion is located within the isosceles trapezoid or spans the extensional break-proof region and the isosceles trapezoid.

4. The screen printing plate for manufacturing a crystalline silicon solar cell of claim 1, wherein the blocking portion is arranged in a lengthwise direction of the positive electrode grid (2).

5. The screen printing plate for manufacturing a crystalline silicon solar cell of claim 1, wherein the blocking portion is arranged in a direction perpendicular to a lengthwise direction of the positive electrode grid (2).

6. The screen printing plate for manufacturing a crystalline silicon solar cell of claim 1, wherein the blocking portion includes one or more blocking portions, so that one or more hollow-out grooves (4) are formed in each break-proof grid structure (3).

7. The screen printing plate for manufacturing a crystalline silicon solar cell of claim 1, wherein the blocking portion is in a shape of a rectangle or circle.

8. The screen printing plate for manufacturing a crystalline silicon solar cell of claim 7, wherein a length and width of the rectangle is selected from a range of 0.034-0.084 mm; and a diameter of the circle is in a range of 0.034-0.084 mm.

9. The screen printing plate for manufacturing a crystalline silicon solar cell of claim 1, wherein a distance between a center of the blocking portion and an edge of the positive electrode busbar (1) is in a range of 0.033-0.068mm.

10. The screen printing plate for manufacturing a crystalline silicon solar cell of claim 3, wherein a width of a lower base of the isosceles trapezoid of the break-proof grid forming region is in a range of 0.050-0.500mm, a width of an upper base of the isosceles trapezoid is the same as a width of the positive electrode grid (2), and a height of the isosceles trapezoid is
in a range of 0.400-1.600mm.
